Europäisches Patentamt

European Patent Office

Office européen des brevets

(11) Publication number: **0 387 887**
**A2**

## (12) EUROPEAN PATENT APPLICATION

(21) Application number: 90104976.7

(51) Int. Cl.⁵: **H01L 23/525**

(22) Date of filing: **16.03.90**

(30) Priority: **17.03.89 JP 65576/89**

(43) Date of publication of application:
**19.09.90 Bulletin 90/38**

(84) Designated Contracting States:
**DE FR GB**

(71) Applicant: **KABUSHIKI KAISHA TOSHIBA**
**72, Horikawa-cho Saiwai-ku**
**Kawasaki-shi Kanagawa-ken 210(JP)**

(72) Inventor: **Hashimoto, Kazuhiko, c/o**
**Intellectual Property Div**
**K.K. Toshiba 1-1 Shibaura 1-chome**
**Minato-ku**
**Tokyo 105(JP)**

(74) Representative: **Lehn, Werner, Dipl.-Ing. et al**
**Hoffmann, Eitle & Partner Patentanwälte**
**Arabellastrasse 4**
**D-8000 München 81(DE)**

(54) Semiconductor device suitable for cutting or joining inter connection layer by charged particles and method of manufacturing the same.

(57) When inter connection layers (15) in an LSI are cut or joined by radiating charged particles, charge is accumulated in the inter connection layers (15). The accumulated charge is discharged, and elements constituting the LSI are damaged. For this reason, a protective diode (D) is arranged near the inter connection layer (15) irradiated with charged particles. The charge accumulated in the inter con-nection layer (15) causes the protective diode (D) to breakdown when the potential of the inter connection layer (15) is increased to a predetermined potential. Therefore, by breakdown of the protective diode (D), the charge accumulated in the inter connection layer (15) is discharged, thus preventing damage to the elements constituting the LSI.

F I G. 2

## Semiconductor device suitable for cutting or joining inter connection layer by charged particles and method of manufacturing the same

The present invention relates to a semiconductor device suitable for cutting or joining inter connection layers by charged particles and a method of manufacturing the semiconductor device.

In a typical semiconductor memory such as a RAM or a ROM, a redundancy circuit is incorporated on a chip to compensate for a decrease in yield in the manufacture of highly integrated large-scaled memory chips at present. For example, spare row and column memory arrays are formed in the memory array portion of a semiconductor memory in advance. When any error of a normal memory array is found at the end of a functional test, fuses are selectively cut to drive the redundancy circuit. The normal memory array is replaced with a spare memory array, thereby increasing the yield of the semiconductor memory.

A YAG laser is currently used for cutting the fuse.

However, in order to cut the fuse using the YAG laser, the fuse must be made of polysilicon because a metal such as aluminum (Aℓ) or molybdenum (Mo) cannot absorb a laser beam and cannot easily be cut. Therefore, the fuse has a high resistance in an inter connection layer. A signal flowing through in the fuse portion incorporated in the inter connection layer is delayed, thereby decreasing an operating speed of the semiconductor memory.

In order to solve this problem, for example, cutting using a focused-ion-beam as described in IEEE TRANSACTIONS ON ELECTRON DEVICES. VOL. 35, NO. 7, JULY 1988, p.899 was proposed.

The fuse can be cut by the focused-ion-beam independently of a composition of a material for the fuse. Therefore, e.g., aluminum (Aℓ) or molybdenum (Mo) having a low resistance can be used for the fuse. The fuse portion has not a high resistance in the inter connection layer, and a decrease in operating speed of the semiconductor memory can be prevented. A portion cut by the focused-ion-beam is smaller than a portion cut by the YAG laser or the like. From this viewpoint, cutting of the fuse using a focused-ion-beam is suitable for a highly integrated semiconductor memory.

In order to cut the fuse using the focused-ion-beam, however, charged particles are radiated onto an inter connection layer in the semiconductor memory. For this reason, in practice, the inter connection layer is charged in the semiconductor memory. As a result, by discharging the accumulated charge, the gate insulating film of a MOSFET and/or capacitor connected to the inter connection layer is damaged, or the semiconductor memory is failed.

The present invention has been made in consideration of the above situation, and has as its object to provide a semiconductor device suitable for cutting and/or joining an inter connection layer by charged particles, wherein, when an LSI inter connection layer is radiated with charged particles, a large amount of charge is not accumulated in the inter connection layer.

It is the second object of the present invention to provide a method of manufacturing a semiconductor device capable of solving the above problems, cutting and/or joining the inter connection layer by charged particles, and modifying a semiconductor device manufactured in one manufacturing process to a plurality of semiconductor devices having other functions.

According to the first aspect of the present invention, there is provided to a semiconductor device comprising:

a plurality of circuits formed on a semiconductor substrate;

an inter connection layer capable of connecting the circuits with each other and including an irradiation region; and

a diode connected to the inter connection layer near the irradiation region.

According to the second aspect of the present invention, there is provided to a method of manufacturing a semiconductor device, comprising the steps of:

a) forming first and second LSI inter connection layers on a semiconductor substrate having first and second LSI forming regions; and

b) changing inter connection layer states of said inter connection layers by radiating charged particles to change functions of said first and second LSIs with each other, wherein a semiconductor device manufactured in one manufacturing process is modified to a plurality of semiconductor devices each having another function.

This invention can be more fully understood from the following detailed description when taken in conjunction with the accompanying drawings, in which:

Fig. 1 is a plan view showing a fuse according to the first embodiment of the present invention;

Fig. 2 is a sectional view taken along a line 2 - 2 in Fig. 1;

Fig. 3 is a sectional view after cutting the programming element shown in Figs. 1 and 2;

Fig. 4 is a plan view showing the programming element according to the second embodiment of the present invention;

Fig. 5 is a sectional view taken along a line 5 - 5 in Fig. 4;

Fig. 6 is a sectional view after joining the programming element shown in Figs. 4 and 5;

Figs. 7A to 7C are sectional views showing steps in manufacturing the fuse according to the third embodiment of the present invention;

Fig. 8 is a sectional view showing the fuse according to the fourth embodiment of the present invention;

Fig. 9 is a plan view showing the fuse according to the fifth embodiment of the present invention;

Figs. 10A to 10C are sectional views showing steps in manufacturing the fuse taken along a line 10 - 10 in Fig. 9 according to the fifth embodiment of the present invention;

Fig. 11 is a sectional view showing the programming element according to the sixth embodiment of the present invention;

Fig. 12 is a plan view showing the fuse according to the seventh embodiment of the present invention;

Fig. 13 is a plan view showing the programming element according to the eighth embodiment of the present invention;

Fig. 14 is a plan view showing the fuse according to the ninth embodiment of the present invention;

Fig. 15 is a sectional view taken along a line 15 - 15 in Fig. 14;

Fig. 16 is a plan view showing the programming element according to the tenth embodiment of the present invention;

Fig. 17 is a sectional view taken along a line 17 - 17 in Fig. 16;

Fig. 18 is a block diagram of a semiconductor memory according to the eleventh embodiment of the present invention;

Fig. 19 is a circuit diagram of a logic circuit according to the twelfth embodiment of the present invention;

Figs. 20A to 20C are sectional views sequentially showing a cutting process of the fuse according to the thirteenth embodiment of the present invention;

Figs. 21A to 21C are sectional views sequentially showing a joining process of the programming element according to the fourteenth embodiment of the present invention;

Figs. 22A to 22C are sectional views sequentially showing a cutting process of the fuse according to the fifteenth embodiment of the present invention;

Figs. 23A to 23C are sectional views sequentially showing a joining process of the programming element according to the sixteenth embodiment of the present invention;

Fig. 24 is a plan view showing the fuse according to the seventeenth embodiment of the present invention;

Fig. 25 is a plan view showing the fuse according to the eighteenth embodiment of the present invention;

Figs. 26A to 26D are sectional views sequentially showing a cutting process of the fuse according to the nineteenth embodiment of the present invention; and

Figs. 27A to 27D are sectional views sequentially showing a joining process of the programming element according to the twentieth embodiment of the present invention.

The embodiments of the present invention will be explained below with reference to the drawings.

Embodiment 1

The first embodiment exemplifies a fuse which is suited to be cut by charged particles.

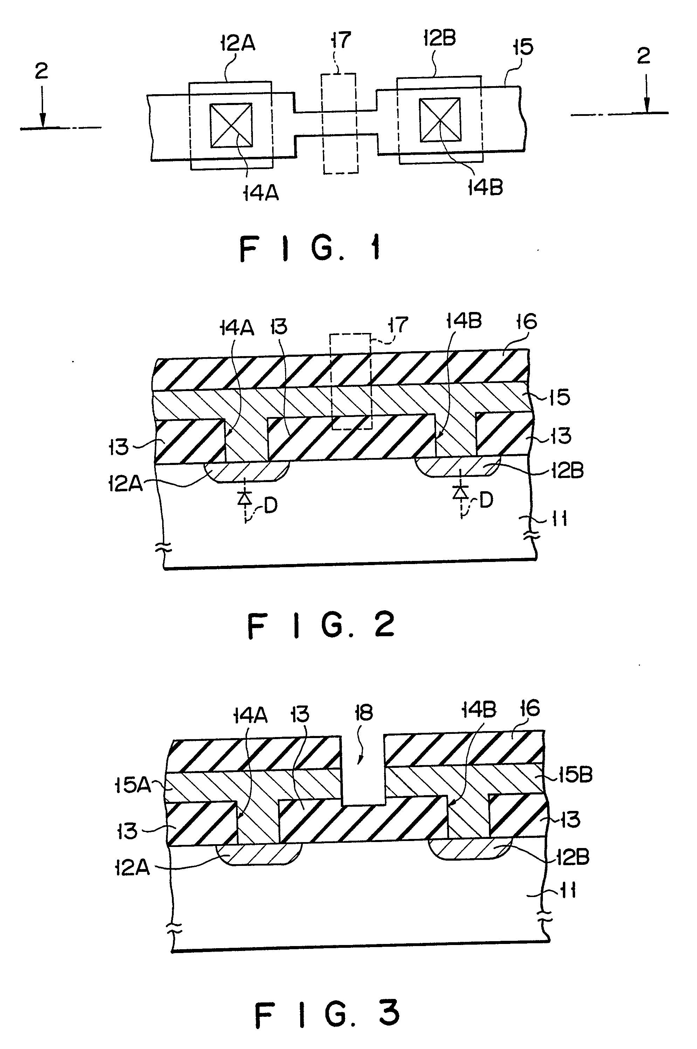

As shown in Figs. 1 and 2, n-type regions 12A and 12B are formed in, e.g., a p-type Si body 11 with a predetermined interval. The n-type regions 12A and 12B are formed by selectively diffusing an n-type impurity such as arsenic (As) and/or phosphorus (P). An insulating film such as an $SiO_2$ film 13 is formed on the Si body 11. Contact holes 14A and 14B are formed in the $SiO_2$ film 13 to expose the n-type region 12A and 12B, respectively. These contact holes 14A and 14B are formed by lithographic techniques using steps in manufacturing LSIs. A metal inter connection layer such as an aluminum/silicon alloy (Aℓ/Si alloy) inter connection layer 15 is formed to have a thickness of 8,000 Å on the $SiO_2$ film 13. The Aℓ/Si alloy inter connection layer 15 contacts the n-type regions 12A and 12B through the contact holes 14A and 14B. An insulating film such as an $SiO_2$ film 16 is formed on the Aℓ/Si alloy inter connection layer 15.

In the fuse with the above arrangement, an irradiation region 17 is set in the inter connection layer 15 located between the n-type regions 12A and 12B. A cutting process of the fuse is performed by radiating charged particles such as a focused-ion-beam onto the irradiation region 17. The focused-ion-beam is radiated using, e.g., gallium as a source at an accelerated voltage of 20 KeV and a current density of 1 to 90 A/cm². Fig. 3 is a sectional view showing the resultant structure after cutting the fuse. As shown in Fig. 3, when the focused-ion-beam is radiated onto the irradiation region 17, the $SiO_2$ film 16 and the Aℓ/Si alloy inter connection layer 15 formed on the irradiation region 17 are sputtered. Reference numeral 18 denotes a sputtered portion. Therefore, as shown in Fig. 3, the inter connection layer 15 is cut into inter connection layers 15A and 15B to be electrically insulated from each other.

At this time, cations generally used as charged particles in the focused-ion-beam are radiated onto the inter connection layer 15. For this reason, the inter connection layer 15 is positively charged, and the voltage of the inter connection layer 15 is increased. In the fuse according to the first embodiment of the present invention, the n-type regions 12A and 12B are connected to both the sides of the irradiation region 17 of the Al/Si alloy inter connection layer 15. The voltages of the n-type regions 12A and 12B are increased in accordance with an increase in voltage of the inter connection layer 15. Protective diodes D each having a p-n junction are formed between the n-type region 12A and the p-type Si body 11 and between the n-type region 12B and the p-type Si body 11. For these reasons, when the voltage of the inter connection layer 15 is increased, the p-n junctions are reverse-biased. When the reverse-biased voltage exceeds a nondestructive breakdown voltage, nondestructive breakdown of the p-n junction occurs. Charge accumulated in the inter connection layer 15 is discharged in the Si body 11 through the n-type regions 12A and 12B, thereby decreasing the voltage of the inter connection layer 15. Therefore, by using the fuse described above, even if the focused-ion-beam using charged particles is radiated to cut the programming element, a large amount of charge is not accumulated in the inter connection layer connected to the programming element. Other gate insulating films of other MOSFETs or the like connected together with the fuse in the inter connection layer are not damaged.

As a result, an LSI having the fuse according to the first embodiment of the present invention is rarely damaged, even if the fuse is cut by charged particles such as a focused-ion-beam.

In the cutting process of the fuse using the focused-ion-beam, unlike a cutting process of the fuse using a laser, interference of a beam with the SiO₂ film on the inter connection layer 15 need not be considered. Therefore, the thick-ness and composition of the SiO₂ film 16 and types of insulating film can be arbitrarily selected.

The conductive film material constituting the inter connection layer 15 can be set as a low-resistance material one with the use of, e.g., an Al/Si alloy, various silicides, aluminum, molybdenum, titanium, cobalt, tantalum, or their alloy, or their multilayer structure, or a multilayer structure of each of all the preceding material and polysilicon. Since the fuse can also be constituted by the same material as that of the inter connection layer 15, the fuse does not have a high resistance.

As a result, a signal flowing through in the inter connection layer is not delayed, and a decrease in operating speed of the LSI can be prevented. In addition, by using the focused-ion-beam, polysilicon can be cut. However, since polysilicon has a high resistance, it is preferred to use a conductive material having a low resistance as a material for the programming element in order to prevent an increase in resistance of the programming element.

The nondestructive breakdown voltage of the p-n junction according to this embodiment is set at about 9 V. For example, a power source voltage in the LSI is set generally at 5 V. When the nondestructive breakdown voltage of the p-n junction is lower than the voltage of the power source, the LSI cannot be operated. Therefore, the above nondestructive breakdown voltage is desirably set at a voltage higher than the power source voltage. When the above nondestructive breakdown voltage is too high, the charge accumulated in the inter connection layer cannot be undesirably discharged. In an LSI using a power source of, e.g., 5 V, the above nondestructive breakdown voltage desirably falls within the range of about 6 V to 15 V.

Note that the focused-ion-beam, an electron beam, or the like can be used as a charged particle beam used for cutting a fuse.

In the first embodiment, cations having a positive charge are used as a focused-ion-beam. However, anions having a negative charge may be used as the focused-ion-beam. In this case, considering a biasing state, it is desirable to convert the n-type regions 12A and 12B to p-type regions and to convert the p-type body 11 to an n-type body.

## Embodiment 2

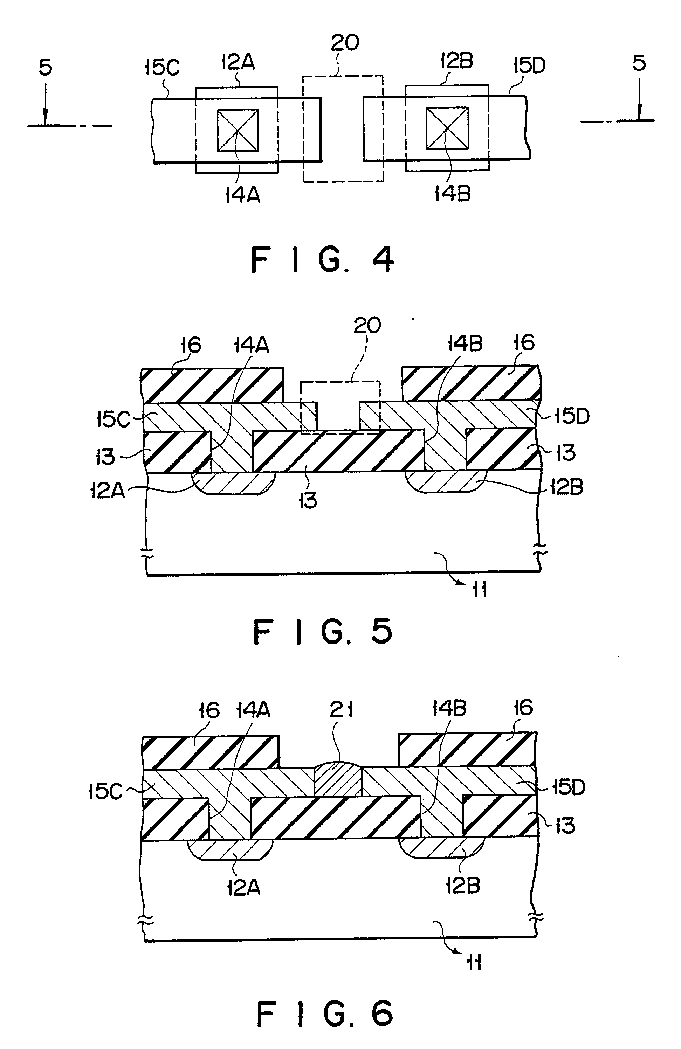

The second embodiment exemplifies a programming element which is suited to be joined by charged particles. The same reference numerals in Figs. 4 to 6 denote the same parts as in Figs. 1 to 3.

As shown in Figs. 4 and 5, n-type regions 12A and 12B are formed in a p-type Si body 11 with a predetermined interval. An Al/Si alloy inter connection layer 15C is connected to the n-type region 12A through a contact hole 14A. Similarly, an Al/Si alloy inter connection layer 15D is connected to the n-type region 12B through a contact hole 14B. The inter connection layers 15C and 15D are isolated and electrically insulated from each other.

In the programming element with the above arrangement, an irradiation region 20 is set between a portion of the inter connection layer 15C to which the n-type region 12A is connected and a portion of the inter connection layer 15D to which the n-type region 12B is connected. An SiO₂ film 16 is removed from the irradiation region 20 in advance. A joining process of programming element is performed to radiate charged particles such as a focused-ion-beam onto the irradiation region 20 while, e.g., a tungsten hexafluoride (WF₆) gas is sprayed thereto. Fig. 6 is a sectional view after joining the programming element. As shown in Fig. 6, when the focused-ion-beam is radiated onto the irradiation region 20 while the WF₆ gas is sprayed thereto, a conductive film 21 as of tungsten is deposited on the irradiation region 20, thereby electrically connecting the inter connection layers 15C and 15D to each other.

In such a joining process, since the focused-ion-beam serving as charged particles is radiated onto the inter connection layers 15C and 15D, the inter connection layers 15C and 15D are charged. In the above programming element, as in the first embodiment, nondestructive breakdown occurs at p-n junctions between the n-type region 12A and the p-type Si body 11 and between the n-type region 12B and the p-type Si body 11 in accordance with an increase in potentials of the inter connection layers 15C and 15D. The potentials of the inter connection layers 15C and 15D can be decreased.

Therefore, when the programming element is joined by charged particles such as a focused-ion-beam, an LSI is rarely failed.

The conductive film material constituting the inter connection layers 15C and 15D can be set as a low-resistance material one with the use of, e.g., an Aℓ/Si alloy, various silicides, aluminum, molybdenum, titanium, cobalt, tantalum, or their alloy, or their multilayer structure, or a multilayer structure of each of all the preceding material and polysilicon. As a conductive film 21 deposited to connect these inter connection layers with each other, tungsten, various silicides, aluminum, molybdenum, titanium, cobalt, tantalum, polysilicon, gold and the like can be used.

Either of cations having a positive charge and anions having a negative charge can be used as the focused-ion-beam. In the latter case, considering the biasing state, it is desirable to convert the n-type regions 12A and 12B to p-type regions and the p-type body 11 to an n-type body, as in the first embodiment.

Embodiment 3

The third embodiment exemplifies a fuse which is suited to be cut by charged particles and a method of manufacturing the same. The same reference numerals in Figs. 7A to 7C denote the same parts as in Figs. 1 to 3.

As shown in Fig. 7A, an SiO₂ film 13 is formed on a p-type Si body 11. Contact holes 14A and 14B which reach the p-type Si body 11 through the SiO₂ film 13 are formed by using lithographic techniques. A polysilicon film 30 containing an n-type impurity such as phosphorus (P) is formed on the entire surface by using CVD. At this time, the polysilicon film 30 contacts the p-type Si body 11 through the contact holes 14A and 14B. A molybdenum silicide film 31 is formed on the entire surface by, e.g., sputtering. Therefore, a multilayered film 32 constituted by the polysilicon film 30 and the molybdenum silicide film 31 can be obtained. The multilayered film 32 is patterned in a predetermined inter connection layer pattern by using lithographic techniques. Note that, since the shape of the multilayered film 32 in the sectional view shown in Fig. 7A is not changed after patterning, the multilayered film 32 is referred to as a multilayered inter connection layer 32 hereinafter.

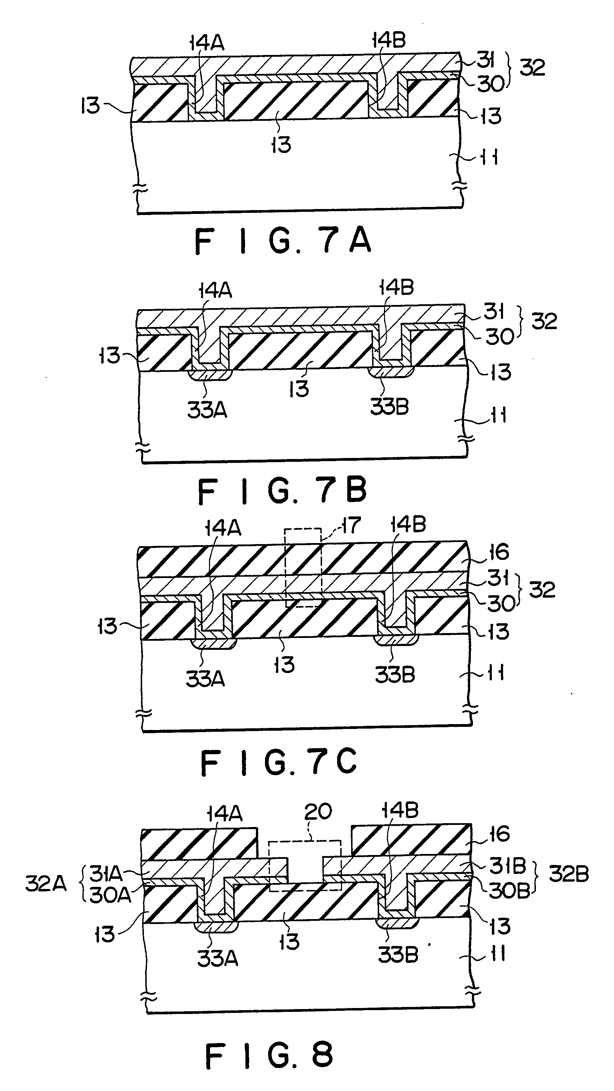

As shown in Fig. 7B, when the resultant structure is annealed at a temperature of 900°C for 30 min., phosphorus (P) contained in the polysilicon film 30 is diffused from the contact portions in the contact holes 14A and 14B into the p-type Si body 11. Therefore, n-type regions 33A and 33B are formed in the p-type Si body 11 with a predetermined interval.

As shown in Fig. 7C, an SiO₂ film 16 is formed on the entire surface by using, e.g., CVD. In the above manufacturing steps, the fuse according to the third embodiment is formed.

An irradiation region 17 is set in the multilayered inter connection layer 32 located between the n-type regions 33A and 33B. A cutting process of a fuse is performed such that charged particles such as a focused-ion-beam are radiated onto the irradiation region 17.

In the fuse of the third embodiment, p-n junctions are formed between the n-type region 33A and the p-type Si body 11 and between the region 33B and the p-type Si body 11. In these p-n junctions, nondestructive breakdown occurs in accordance with an increase in potential of the multilayered inter connection layer 32 caused by radiating a focused-ion-beam.

Therefore, as in the first embodiment, even if the fuse is cut by charged particles such as a focused-ion-beam, an LSI is rarely failed.

Therefore, the inter connection layer may be made of the multilayered film constituted by the different types of conductive films. When the polysilicon film 30 is used as one layer of the multilayered film, a low-resistance conductive film as of molybdenum silicide film 31 is formed on the polysilicon film 30, thereby preventing an increase in resistance of the inter connection layer. At the same time, an increase in resistance of the fuse can also be prevented.

When the polysilicon film 30 contacts the p-type Si body 11 in the contact holes 14A and 14B, the n-type regions 33A and 33B can be formed in the p-type Si body 11 by diffusing an n-type impurity from the polysilicon film 30. Therefore, an n-type region need not to be formed in the p-type Si body 11 in advance, thus simplifying the manufacturing steps. In addition, the n-type regions 33A and 33B for forming p-n junctions can be formed with respect to the contact holes 14A and 14B in self-alignment.

## Embodiment 4

The fourth embodiment exemplifies a programming element which is suited to be joined by charged particles. The same reference numerals in Fig. 8 denote the same parts as in Figs. 4 to 7, and only different parts will be described below.

As shown in Fig. 8, a multilayered inter connection layer 32A constituted by an n-type polysilicon film 30A and a tungsten silicide film 31A are isolated and electrically insulated from a multilayered inter connection layer 32B constituted by an n-type polysilicon film 30B and a tungsten silicide film 31B. The multilayered inter connection layer 32A is connected through a contact hole 14A to an n-type region 33A formed in a p-type Si body 11 by diffusing an impurity from the n-type polysilicon film 30A. The multilayered inter connection layer 32B is connected through a contact hole 14B to an n-type region 33B formed in a p-type Si body 11 by diffusing an impurity from the n-type polysilicon film 30B.

An irradiation region 20 is set between a portion of the multilayered inter connection layer 32A connected to the n-type region 33A and a portion of the multilayered inter connection layer 32B connected to the n-type region 33B. An SiO₂ film 16 is removed from the irradiation region 20 in advance.

As described above, the arrangement of the programming element described in the third embodiment may be used for a charged particle for joining programming element.

## Embodiment 5

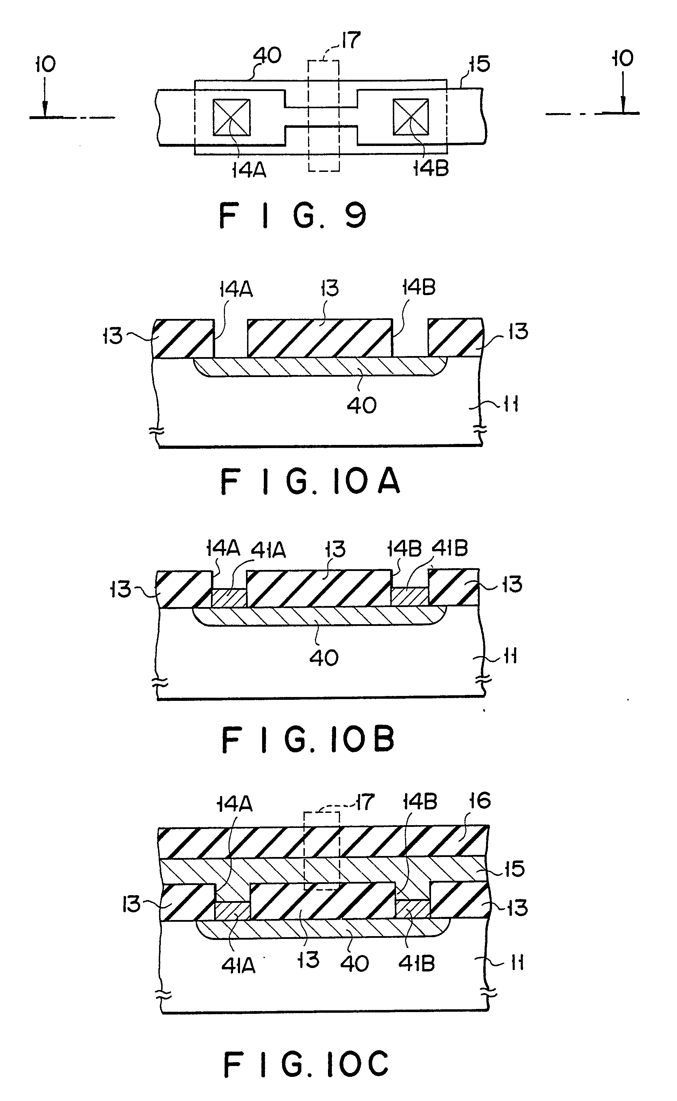

The fifth embodiment exemplifies a fuse which is suited to be cut by charged particles and a method of manufacturing the same. The same reference numerals in Figs. 9 to 10C denote the same parts as in Figs. 1 to 3.

As shown in Fig. 10A, an n-type region 40 is selectively formed by using photolithography in a p-type Si body 11. An SiO₂ film 13 is formed on the entire surface of the resultant structure by using, e.g., CVD, and contact holes 14A and 14B which reach an n-type region 40 through the SiO₂ film 13 are formed by using photolithography.

As shown in Fig. 10B, a high-resistance polysilicon film is formed by using CVD and etched back to form high-resistance regions 41A and 41B constituted by polysilicon in the contact holes 14A and 14B.

As shown in Figs. 9 and 10C, an Aℓ/Si alloy is formed by using, e.g., sputtering, and is patterned to a predetermined Aℓ/Si alloy inter connection layer 15. An SiO₂ film 16 is formed on the entire surface of the resultant structure by using, e.g., CVD.

According to the fuse with the above arrangement, the contact holes 14A and 14B are connected to a single n-type region 40. An irradiation region 17 is set in the inter connection layer 15 located between the contact holes 14A and 14B.

In the above described fuse, even if the irradiation region 17 is cut by a focused-ion-beam serving as charged particles, the cut inter connection layers are conducted with each other through the n-type region 40. As shown in the fifth embodiment, the problem is solved by forming the high-resistance regions 41A and 41B having resistances of about 1 MΩ in the contact holes 14A and 14B. That is, the resistances of the high-resistance regions 41A and 41B are increased, and a circuit is designated such that a current which flows through the n-type region 40 is not generated by a power source voltage of an LSI or an operating voltage, e.g., 5 V. Therefore, a current which flows between the cut inter connection layers can be substantially eliminated.

In this embodiment, the resistance of each of the high-resistance regions 41A and 41B is set at 1 MΩ. This resistance is set at 10 KΩ or more to form a fuse with the above arrangement. As LSIs are designed in consideration of various factors in practice, its resistance preferably falls within the range of 1 MΩ to 1 GΩ.

## Embodiment 6

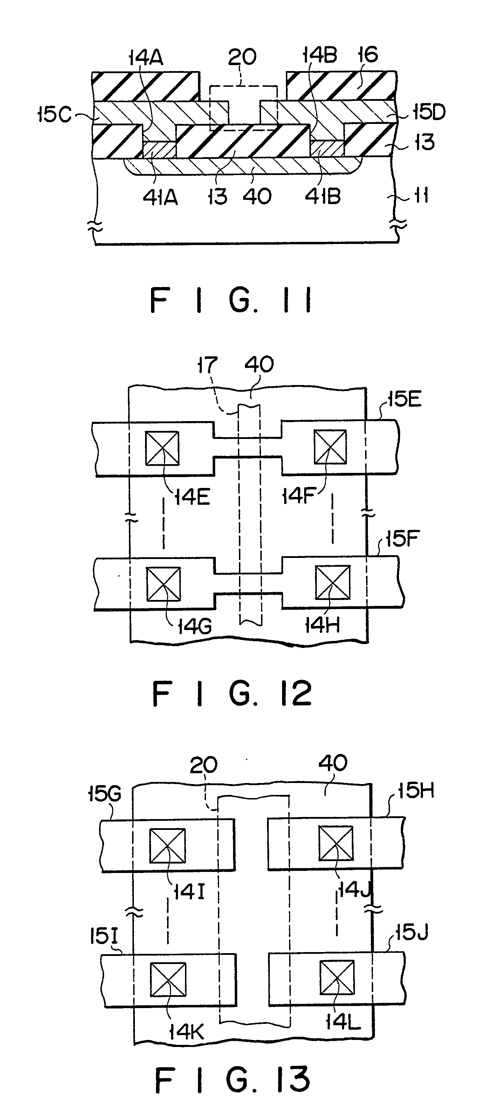

The sixth embodiment exemplifies a programming element which is suited to be joined by charged particles. The same reference numerals in Fig. 11 denote the same parts as in Figs. 4 to 6 and in Figs. 9 to 10, and only different parts will be described below.

As shown in Fig. 11, inter connection layers 15C and 15D are isolated and electrically insulated from each other. The inter connection layer 15C is connected to an n-type region 40 through a high-resistance region 41A formed in a contact hole 14A. The inter connection layer 15D is connected to the n-type region 40 through a high-resistance region 41B formed in a contact hole 14B.

An irradiation region 20 is set between a portion of the inter connection layer 15C to which the n-type region 40 is connected and a portion of connected to the n-type region 40 of the inter connection layer 15D. An SiO₂ film 16 is removed from the irradiation region 20 in advance.

In this manner, the structure of the programming element described in the fifth embodiment may be used for a charged particle for joining programming element. In this case, a resistance of each of the high-resistance regions 41A and 41B is 10 KΩ or more to form the programming element with the above arrangement. As described in the fifth embodiment, the resistance preferably falls within the range of 1 MΩ to 1 GΩ.

Embodiment 7

The seventh embodiment exemplifies a fuse which is suited to be cut by charged particles. The same reference numerals in Fig. 12 denote the same parts as in Figs. 9 to 10, and only different parts will be described below.

As shown in Fig. 12, according to the structure of the fuse described in the fifth embodiment, inter connection layers 15E and 15F can be formed on a single n-type region 40. High-resistance regions (not shown in Fig. 12) are formed in contact holes 14E to 14H. In addition, the n-type region 40 is formed in a p-type Si body.

Embodiment 8

The eighth embodiment exemplifies a programming element which is suited to be joined by charged particles. The same reference numerals in Fig. 13 denote the same parts as in Fig. 11, and only different parts will be described below.

As shown in Fig. 13, according to the structure of the programming element described in the sixth embodiment, a plurality of inter connection layers 15G to 15J can be formed on a single n-type region 40. High-resistance regions (not shown in Fig. 13) are formed in contact holes 14I to 14L. In addition, the n-type region 40 is formed in a p-type Si body.

Embodiment 9

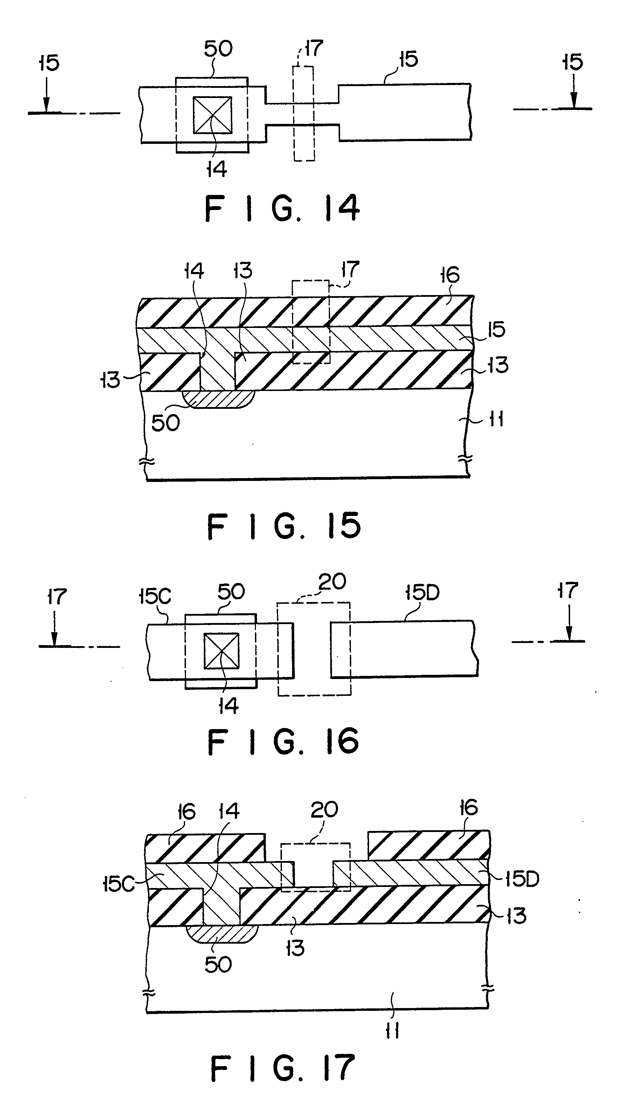

The ninth embodiment exemplifies a fuse which is suited to be cut by charged particles. The same reference numerals in Figs. 14 and 15 denote the same parts as in Figs. 1 to 3, and only different parts will be described below.

As shown in Figs. 14 and 15, even if at least one n-type region 50 is connected to an inter connection layer 15, the same effect as in the above embodiment can be obtained.

An irradiation region 17 in a programming element with this arrangement is set near a contact hole 14. In this manner, charge accumulated in the inter connection layer by radiating charged particles can be discharged to a p-type Si body 11 through an n-type region 50.

Embodiment 10

The tenth embodiment exemplifies a programming element which is suited to be joined by charged particles. The same reference numerals in Figs. 16 and 17 denote the same parts as in Figs. 4 to 6, and only different parts will be described below.

As shown in Figs. 16 and 17, in a programming element, only at least one n-type region 50 is connected to an inter connection layer 15C.

An irradiation region 20 in a programming element with this arrangement is defined by a position where a contact hole 14 of the inter connection layer 15C opposes an inter connection layer 15D. In this manner, charge accumulated in the inter connection layers 15C and/or 15D by radiating charged particles can be discharged to a p-type Si body 11 through an n-type region 50.

Embodiment 11

In the eleventh embodiment exemplifies the fuse of the above embodiments used for a semiconductor memory.

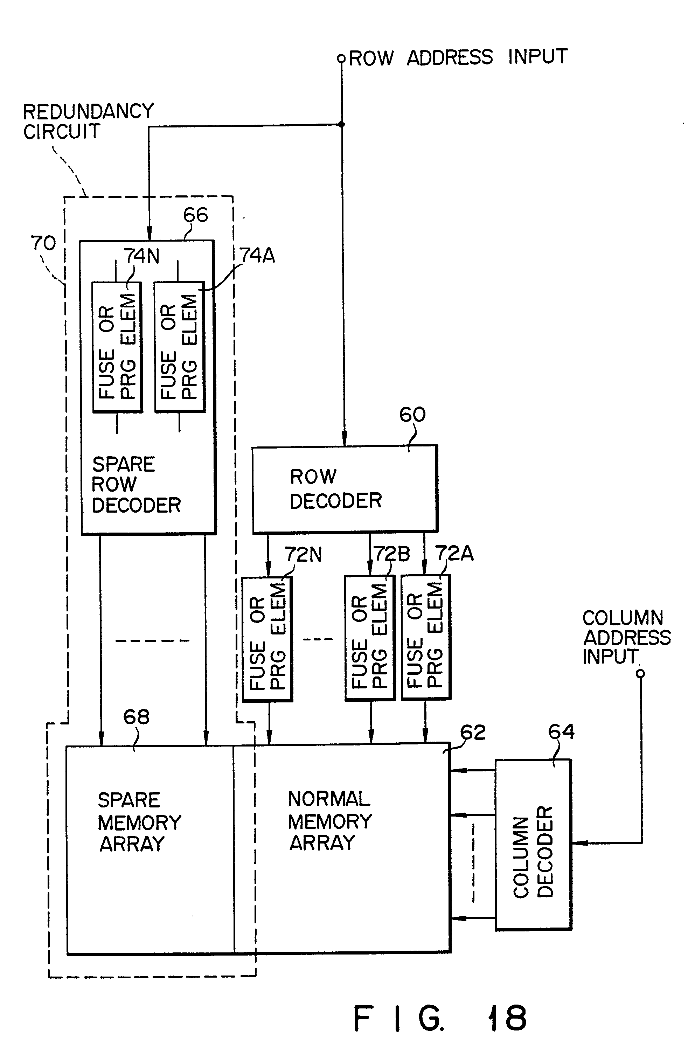

As shown in Fig. 18, a row address signal is input to a row decoder 60. This row address signal is decoded by the row decoder 60, and a predetermined row of a normal memory array 62 is selected by the decoded signal. A column address signal is input to a column decoder 64 and decode by the column decoder 64, so that a predetermined column of the normal memory array is selected by the decoded signal.

A redundancy circuit 70 is constituted by a spare row decoder 66 and a spare memory array 68. When the failed cell occurs in the normal memory array 62, the redundancy circuit 70 is used for replacing a row corresponding to a failed cell to a spare row. The redundancy circuit 70 is incorporated in a semiconductor memory block.

When a fuse is suited to be cut by charged particles, fuses 72A to 72N corresponding to the row of the failed cell are selectively cut, thereby electrically insulating the row of the failed cell. Fuses 74A to 74N incorporated in the spare decoder 66 are selectively cut such that a spare row of the spare memory cell array 68 is selected by the spare decoder 66 when a row address signal for selecting the row of the filed cell is input. Therefore, the row connected to the filed cell of the normal memory cell allay 62 is replaced to the spare row of the spare memory cell array 68.

In a semiconductor memory in which such a redundancy circuit 70 is incorporated, the fuse of the above embodiment is used as the fuses 72A to 72N and 74A to 74N. Therefore, when the fuse is cut by, e.g., a focused-ion-beam, a non-failed semiconductor memory can be obtained.

In addition, a semiconductor memory may be designated such that a row connected to a failed cell of the normal memory array 62 is replaced to a spare row of the spare memory array 68 by connecting a programming element (PRG ELEM). The programming elements of the above embodiments are used as the programming elements 72A to 72N and 74A to 74N. Therefore, if the programming elements are joined by, e.g., a focused-ion-beam, a non-failed semiconductor memory can be obtained.

Embodiment 12

The twelfth embodiment exemplifies a method of incorporating a programming element in an LSI and joining or cutting an inter connection layer with a charged-particle beam, thus obtaining an LSI having another function.

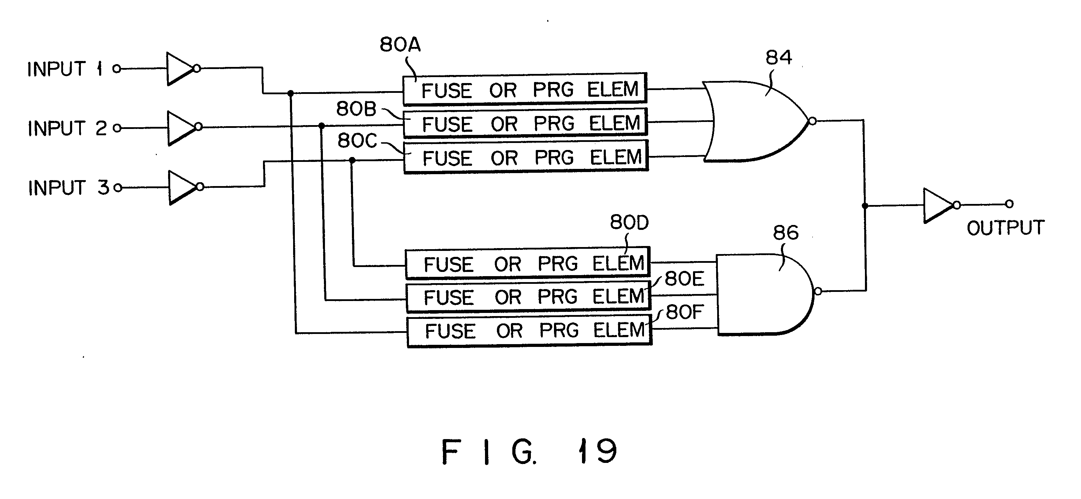

As shown in Fig. 19, input terminals of a NOR gate 84 are connected to inputs 1 to 3 through programming elements or fuses 80A to 80C, respectively, and its output terminal is connected to a single output. Input terminals of a NAND gate 86 are connected to the inputs 1 to 3 through programming elements or fuses 80D to 80F, respectively, and its output terminal is connected to the single output.

For example, when the fuses 80D to 80F connected to the input terminals of the NAND gate 86 are cut, this circuit functions as a 3-input type NOR circuit. When the fuses 80A to 80C connected to the output terminals of the NOR gate 84 are cut, this circuit functions as a 3-input type NAND circuit.

Thus, when only the fuses 80A to 80C or fuses 80D to 80F are selectively cut, LSIs each having another function can be obtained.

In the steps in manufacturing LSIs, the above method can be employed together with an inter connection layer mask pattern (reticle). After formation of an inter connection layer pattern, when only fuse to be cut are selected, LSIs each having another function such as a NOR circuit or a NAND circuit can be obtained. In the steps after cutting fuse, the method and the inter connection layer mask pattern can be used with each other.

According to the method, LSIs each having another function can be manufactured only by selectively cutting fuse, inexpensive ASICs or the like which are products ordered in a small quantity can be provided.

A plurality of LSIs each having another function can be manufactured from a single wafer.

In the method, since the fuses of the above embodiment are used as the programning elements 80A to 80F, even if the fuses are cut by a focused-ion-beam, LSIs can be prevented from failure.

In the circuit shown in Fig. 19, when programning elements are joined, LSIs having the above effects can be manufactured. For example, when the programming elements 80A to 80C are joined, this circuit functions as a 3-input type NOR circuit. When the programming elements 80D to 80F are joined, this circuit functions as a 3-input type NAND circuit. In addition, since programming elements of the above embodiments are used as the replaced programming elements 80A to 80F, even if the programming elements are joined by a focused-ion-beam, LSIs can be prevented from failure.

Embodiment 13

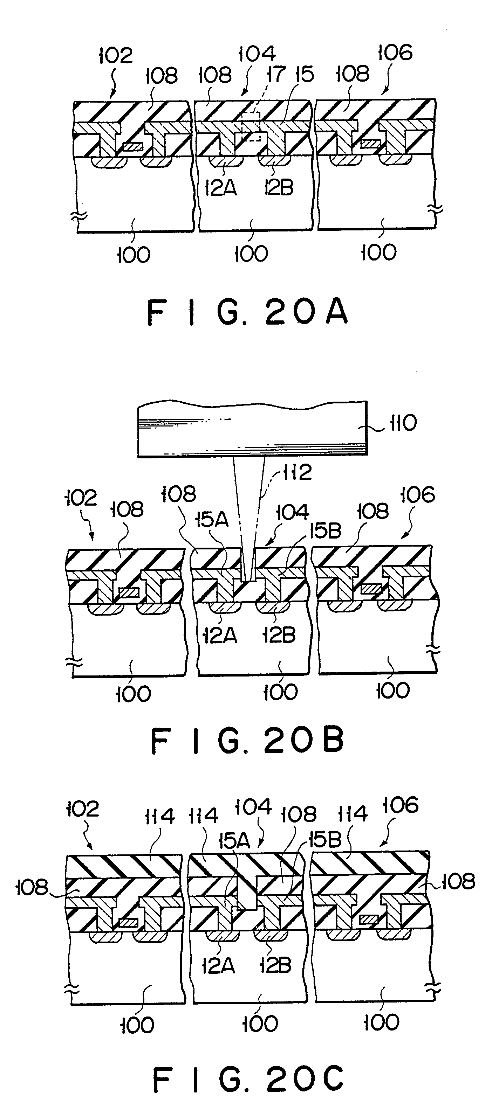

The thirteenth embodiment exemplifies, particularly, steps in cutting fuse of LSIs having fuses of the above embodiments. The same reference numerals in Figs. 20A to 20C denote the same parts as in Figs. 1 to 3.

As shown in Fig. 20A, active elements 102 and 106 consisting of an LSI are formed on an Si body 100. At the same time, a fuse 104 of the above embodiments is formed. Then, a protective film 108 such as an $SiO_2$ film is formed thereon.

Thereafter, as shown in Fig. 20B, a functional test of the LSI is performed using a wafer prober or the like, and good or failed products are screened. In the manufacture of semiconductor memories, fuse 104 to be cut of a failed product are selected in the manner described in the eleventh embodiment. An inter connection layer 15 is cut into inter connection layers 15A and 15B by radiating a focused-ion-beam 112 from an ion beam radiator 110.

Thereafter, a functional test is performed to an LSI in which the fuse 104 is cut.

As shown in Fig. 20C, the entire surface of the resultant structure is coated with a polyimide film 114 or the like, thereby burying the cut portion. An undercoat material used for coating an LSI after dicing and wire-bonding are performed can be used in place of the polyimide film 114.

In LSIs incorporating fuses according to the present invention, a cutting process of a fuse may be performed after performing wafer process and a functional test. Since a fuse is cut after formation of the protective film 108, the method of this embodiment is preferably selected for particularly manufacturing semiconductor memories.

A hole formed in a portion where a fuse is cut by a focused-ion-beam can be buried in the step in undercoating of the steps in assembly, and the number of steps is not increased.

Embodiment 14

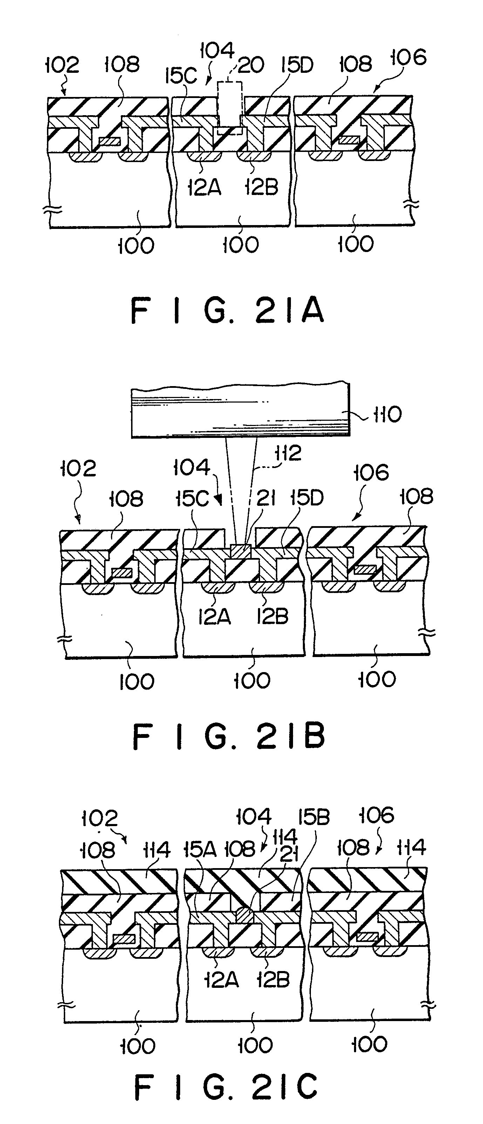

The thirteenth embodiment exemplifies, particularly, steps in joining programming element of LSIs having programming elements of the above embodiments. The same reference numerals in Figs. 21A to 21C denote the same parts as in Figs. 4 to 6.

As shown in Fig. 21A, a protective film 108 is formed on the entire surface of an LSI. The protective film 108 is removed from an irradiation region 20 using lithography.

Thereafter, as in the thirteenth embodiment, a functional test of the LSI is performed using a wafer prober or the like, and good or failed products are screened. In a semiconductor memory, for example, programming elements to be joined are selected. As shown in Fig. 21B, a focused-ion-beam is radiated from an ion beam radiator 110 onto the irradiation region 20. At the same time, a $WF_6$ gas is sprayed to the irradiation region 20, thus depositing a conductive film 21. As a result, inter connection layers 15C and 15D are connected with each other.

As shown in Fig. 21C, the resultant structure is coated with the polyimide film 108.

Therefore, the method as described in the thirteenth embodiment can be employed in a joining process of programming element.

Embodiment 15

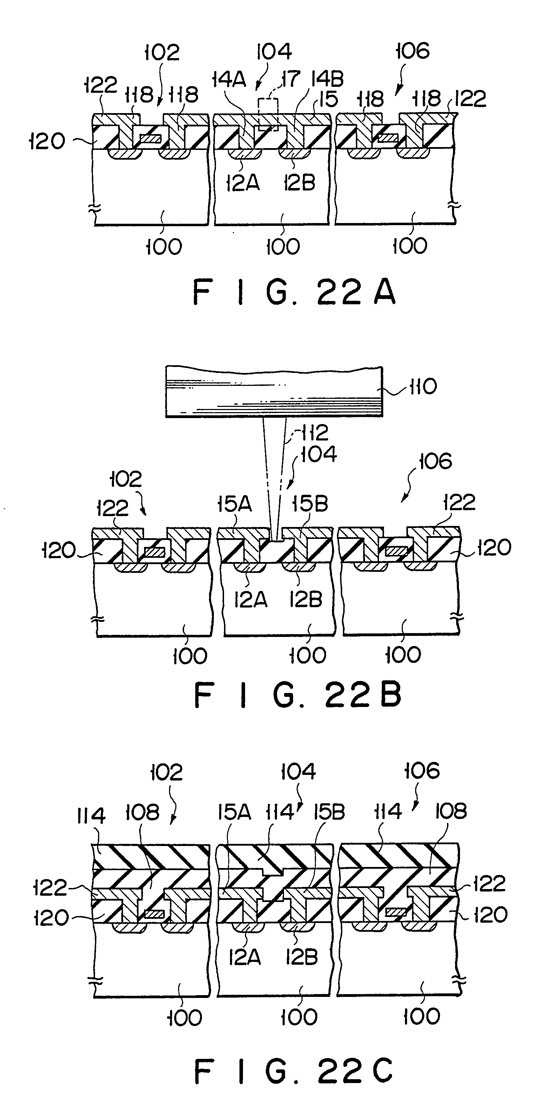

The fifteenth embodiment exemplifies, particularly, steps in cutting fuse of LSIs having fuses of the above embodiments. The same reference numerals in Figs. 22A to 22C denote the same parts as in Figs. 20A to 20C.

As shown in Fig. 22A, an insulating interlayer 120 is formed, and contact holes 14A, 14B, 118 and the like are formed in predetermined portions of an LSI. Thereafter, an Aℓ/Si alloy or the like is deposited on the entire surface of the resultant structure by sputtering. The Aℓ/Si alloy is patterned to form inter connection layers 15 and 122.

Thereafter, in order to manufacture such LSIs as described in the twelfth embodiment, for example, a fuse 104 to be cut is selected to form a desired logic circuit. As shown in Fig. 22B, a focused-ion-beam 112 is radiated from an ion beam radiator 110 onto an irradiation region 17 of the fuse to cut an inter connection layer 15 into inter connection layers 15A and 15B.

As shown in Fig. 22C, a protective film 108 is formed on the entire surface of the resultant structure by, e.g., CVD.

Therefore, a functional test of LSIs is performed by using a wafer prober to screen good and failed products.

The entire surface of resultant structure is coated with the polyimide 114 or the like, thereby burying the cut portions.

In an LSI incorporating fuses according to the present invention, fuse cutting may be performed after the step in forming inter connection layers of a wafer process. Since a fuse is cut before forming a protective film 108, the method of this embodiment is preferably selected for manufacturing such an LSI as described in the twelfth embodiment.

Note that some fuses may be cut after inter connection layers are formed, and other fuses may be cut using, e.g., the method described in the thirteenth embodiment after a protective film is formed.

Embodiment 16

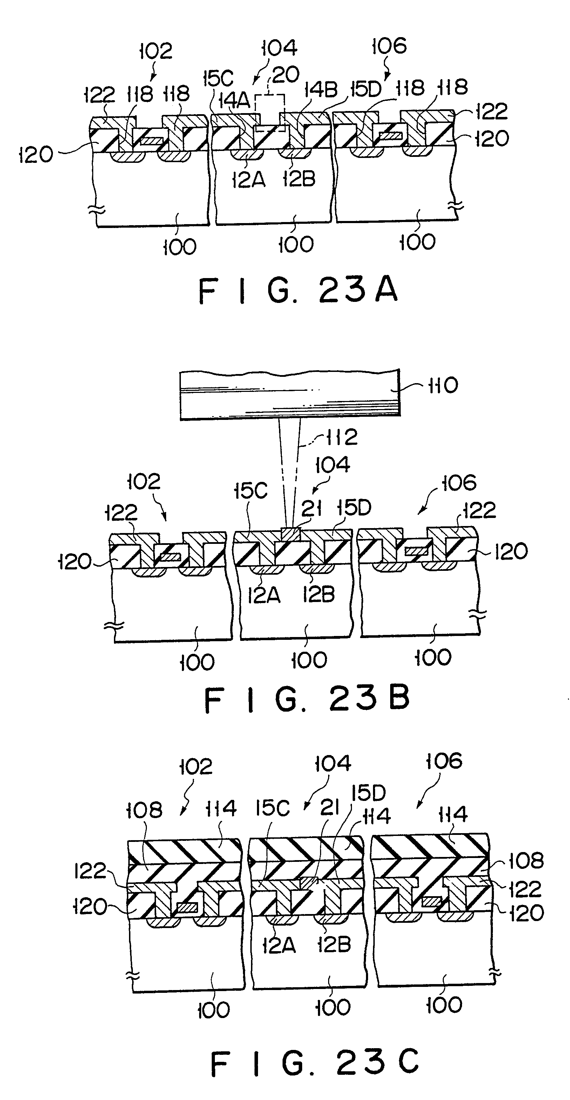

The sixteen embodiment exemplifies, particularly, steps in joining programming element of LSIs having programming elements of the above embodiments. The same reference numerals in Figs. 23A to 23C denote the same parts as in Figs. 21A to 21C and 22A to 22C.

As shown in Fig. 23A, as in the fifteenth embodiment, an insulating interlayer 120 is formed, and contact holes 14A, 14B and 118 are formed. Inter connection layers 15C, 15D and 122 are formed.

Thereafter, in order to manufacture the LSI as described in the twelfth embodiment, a programming element 104 to be joined is selected to form a desired logic circuit. As shown in Fig. 22B, a focused-ion-beam 112 is radiated from an ion beam radiator 110 onto an irradiation region 21 of the programming element while a $WF_6$ gas is sprayed to deposit a conductive film 21. Thus, the inter connection layers 15C and 15D are connected with each other.

As shown in Fig. 23C, a protective film 108 is formed on the entire surface of the resultant structure by, e.g., CVD.

Therefore, a functional test of LSIs is performed by using a wafer prober to screen good and failed products.

The entire surface of resultant structure is coated with the polyimide 114 or the like, thereby burying the cut portions.

As described above, the method described in the fifteenth embodiment can be employed in programming elements joining.

## Embodiment 17

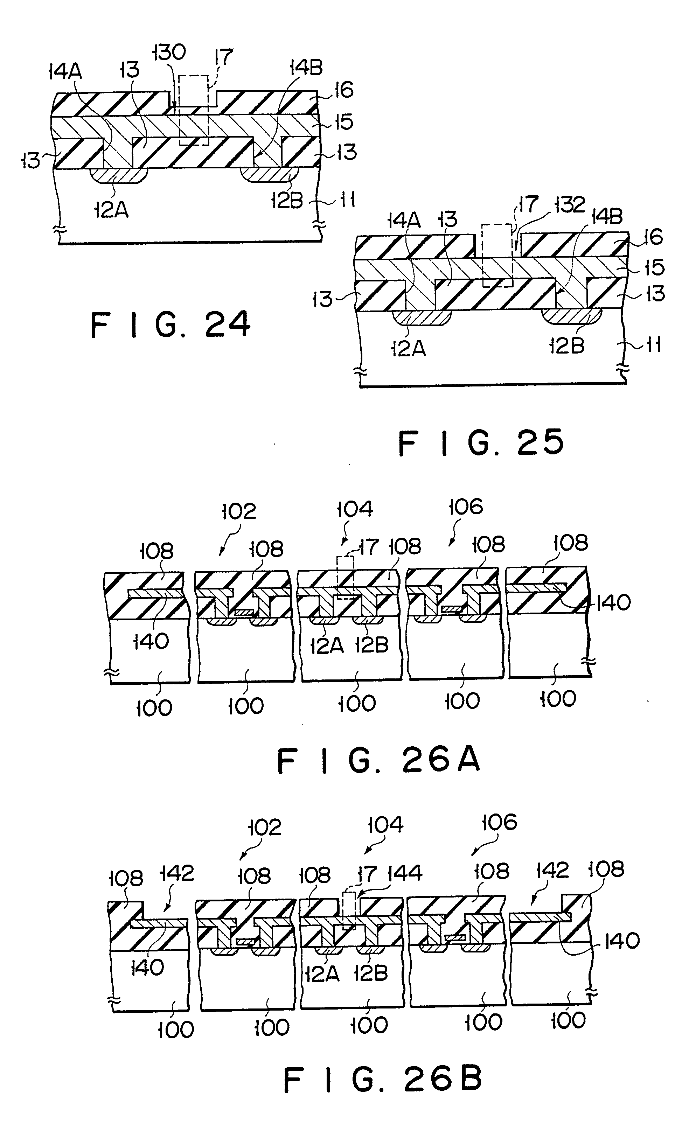

The seventeenth embodiment exemplifies a fuse which is suited to be cut by charged particles. The same reference numerals in Fig. 24 denote the same parts as in Figs. 1 to 3, and only different parts will be described below.

As shown in Fig. 24, an insulating film 130 formed on an irradiation region 17 may be formed thinner than an insulating film 16 formed on the another inter connection layer of the LSI.

In this case, since the thin insulating film 130 formed on the irradiation region 17 is formed, a period of time required for cutting the fuse can be shortened.

## Embodiment 18

The eighteenth embodiment exemplifies a fuse which is suited to be cut by charged particles. The same reference numerals in Fig. 25 denote the same parts as in Figs. 1 to 3, and only different parts will be described below.

As shown in Fig. 25, an insulating film 16 need not be formed on an irradiation region 17 indicated by reference numeral 132.

In this case, since any insulating film is not formed on the irradiation region 17, a period of time required for cutting the fuse can be further shortened.

## Embodiment 19

The nineteenth embodiment exemplifies, particularly, a method of cutting fuse of LSIs having fuses of the above embodiments. The same reference numerals in Figs. 26A to 26D denote the same parts as in Figs. 20A to 20C.

As shown in Fig. 26A, as in the thirteenth embodiment, active elements 102 and 106 constituting an LSI are formed on an Si substrate 100. At the same time, a fuse 104 of the above embodiment is formed thereon. Note that a portion near bonding pads 140 is also shown in Fig. 26A. A protective film 108 is formed.

As shown in Fig. 26B, openings 142 which reach the bonding pads 140 are formed in the protective film 108 by using lithographic techniques. At the same time, an opening 144 which reaches an irradiation region 17 of the fuse 104 is formed.

Thereafter, a functional test is performed.

As shown in Fig. 26C, a fuse to be cut is selected, and the selected fuse 104 is cut by a focused-ion-beam 112.

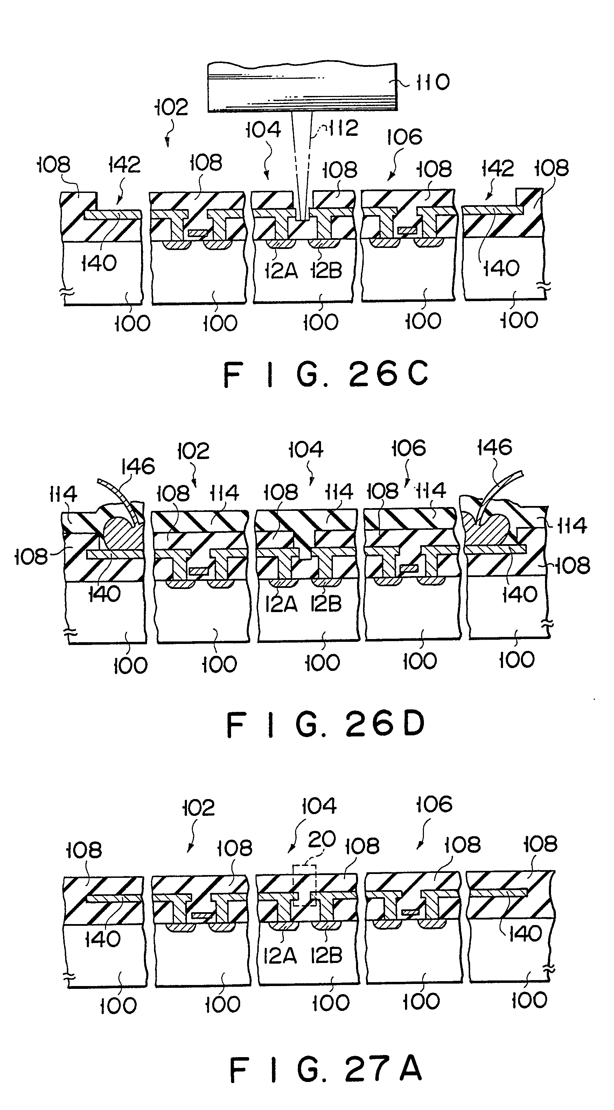

Thereafter, after a functional test is performed again, dicing is performed to divide the wafer into LSI chips. Each of LSI chips which is determined to be good is die-bonded on a bed. Thereafter, as shown in Fig. 26D, wires 146 are bonded to the bonding pads 140. An undercoating is performed by, e.g., a polyimide film 114.

When the openings 142 which reach the bonding pads 140 are formed, the opening 144 which reaches the cutting region 17 is simultaneously formed. Therefore, fuse, as described in the seventeenth or eighteenth embodiment, capable of shortening a period of time required for cutting the fuses without increasing the number of step, can be obtained.

## Embodiment 20

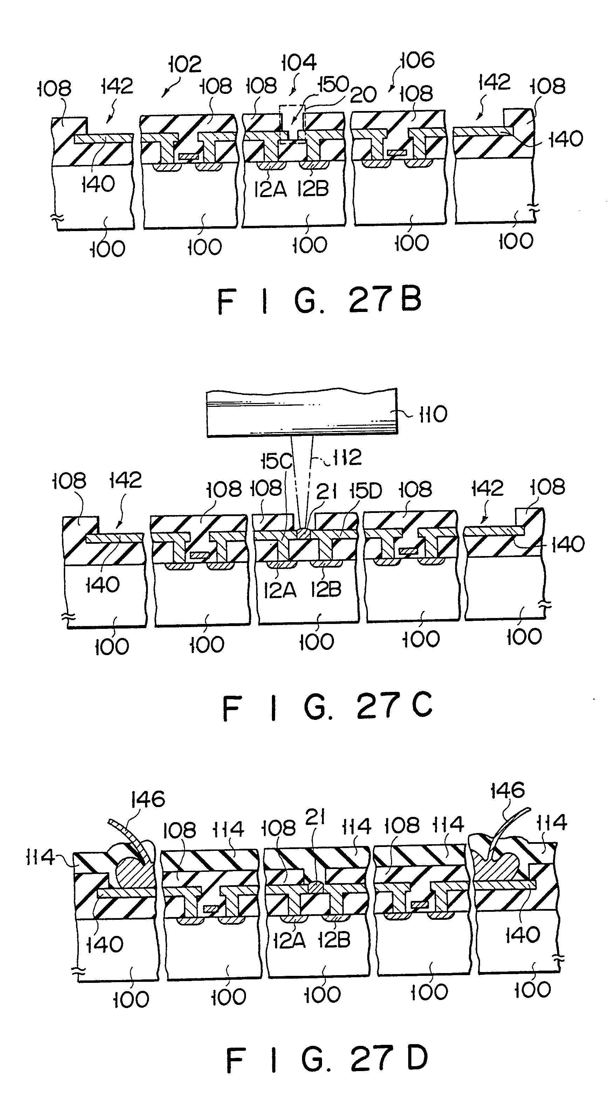

The twentieth embodiment exemplifies, particularly, a method of joining programming element of LSIs having programming elements of the above embodiments. The same reference numerals in Figs. 27A to 27D denote the same parts as in Figs. 21A to 21C and 26A to 26D.

As shown in Fig. 27A, as in the fifteenth embodiment, active elements 102 and 106 constituting an LSI are formed on an Si substrate 100, and at the same time, a programming element 104 of the above embodiment is formed thereon. Note that a portion near bonding pads 140 is also shown in Fig. 27A. A protective film 108 is formed.

As shown in Fig. 27B, openings 142 which reach the bonding pads 140 are formed in the protective film 108 by using lithographic techniques. At the same time, an opening 150 is formed by removing the protective film 108 on an irradiation region 20.

Thereafter, a functional test is performed.

As shown in Fig. 27C, a programming element to be joined are selected. After the selection, a focused-ion-beam 112 is radiated onto each of the programming element 104 to be joined while a $WF_6$ gas is sprayed thereto to form a conductive film 21. Therefore, inter connection layers 15C and 15D are connected with each other.

Thereafter, after a functional test is performed again, and dicing and die bonding are performed, as described in the nineteenth embodiment. Subsequently, as shown in Fig. 20D, wire bonding is performed, and undercoating is performed by, e.g., a polyimide film 114.

As described above, for the programming element, the film 108 to be removed from the irradiation region 20 is removed simultaneously with formation of the openings 142 which reach the bonding pads 140. Therefore, the opening 150 is formed on the irradiation region 20 without increasing the number of steps, and the programming elements of the above embodiment can be obtained.

Reference signs in the claims are intended for better understanding and shall not limit the scope.

## Claims

1. A semiconductor device including:
a plurality of circuits (60, 62) formed on a semiconductor substrate (11) characterized by comprising;
an inter connection layer (15) capable of connecting said circuits with each other and including an irradiation region (17, 20); and
a diode (D) connected to said inter connection layer near said irradiation region.

2. A device according to claim 1, characterized in that said diode is constituted by first and second diodes connected to both the sides of said irradiation region.

3. A device according to claim 1, characterized in that said inter connection layer is separated into a first inter connection layer (15A) and a second inter connection layer (15B) at said irradiation region.

4. A device according to claim 3, characterized in that said first and second inter connection layers are connected to a single diode.

5. A device according to claim 3, characterized in that said first and second inter connection layers are connected to first and second diodes, respectively.

6. A device according to claims 1, 2 and 4, characterized in that said diode is a p-n junction diode.

7. A device according to claim 5, characterized in that said first and second diodes are p-n junction diodes.

8. A device according to claim 1, characterized in that said diode is connected to said inter connection layer through a resistor.

9. A device according to claim 4, characterized in that said diode is connected to said first and second wirings through a first resistor (40A) and a second resistor (40B), respectively.

10. A device according to claim 8, characterized in that said resistor has a resistance of not less than 10 KΩ.

11. A device according to claim 9, characterized in that each of said first and second resistors has a resistance of not less than 10 KΩ.

12. A device according to claims 1, 2 and 4, characterized in that a breakdown voltage of said diode is not less than a power source voltage.

13. A device according to claim 5, characterized in that breakdown voltages of said first and second diodes are not less than a power source voltage.

14. A device according to claims 6 and 7, characterized in that a breakdown voltage of said p-n junction diode is not less than a power source voltage.

15. A device according to claim 1, characterized in that said circuit (60) includes decoder, and said circuit (62) includes memory cell array.

16. A device according to claims 1, 2 and 3, characterized in that said inter connection layer is made of a metal.

17. A device according to claims 1, 2 and 3, characterized in that said inter connection layer has a multilayered film constituted by different types of conductive films.

18. A device according to claim 1, characterized in that an insulating film (130) formed on said irradiation region is thinner than an insulating film (16) formed on said inter connection layer.

19. A device according to claim 1, characterized in that any insulating film is not formed on said irradiation region.

20. A method of manufacturing a semiconductor device characterized by comprising the steps of:
    a) forming elements (102, 104, 106) on a semiconductor substrate;
    b) forming an insulating film (120) for insulating said elements (102, 104, 106) from each other;
    c) forming openings (14A, 14B, 118) for exposing predetermined portions through said insulating film (120);
    d) entirely forming a conductive film and etching the conductive film to pattern inter connection layer (15, 15A, 15B, 122); and
    e) cutting or joining said inter connection layer (15, 15A, 15B, 122) by radiating charged particles onto the patterns of said inter connection layer (15, 15A, 15B, 122).

21. A method according to claim 20, characterized by further comprising the step of entirely forming an insulating film after the step d).

22. A method of manufacturing a semiconductor device, characterized by comprising the steps of:
    a) forming first and second LSI inter connection layer on a semiconductor substrate (11) having

11

first and second LSI forming regions; and

b) changing inter connection layer states of said wirings by radiating charged particles to change functions of said first and second LSIs with each other.

F I G. 1

F I G. 2

F I G. 3

F I G. 4

F I G. 5

F I G. 6

F I G. 7A

F I G. 7B

F I G. 7C

F I G. 8

F I G. 9

F I G. 10A

F I G. 10B

F I G. 10C

F I G. 11

F I G. 12

F I G. 13

EP 0 387 887 A2

F I G. 14

F I G. 15

F I G. 16

F I G. 17

EP 0 387 887 A2

ROW ADDRESS INPUT

REDUNDANCY CIRCUIT

66

70

74N    74A

FUSE OR PRG ELEM    FUSE OR PRG ELEM

SPARE ROW DECODER

60

ROW DECODER

72N    72B    72A

FUSE OR PRG ELEM    FUSE OR PRG ELEM    FUSE OR PRG ELEM

COLUMN ADDRESS INPUT

68

62    64

SPARE MEMORY ARRAY

NORMAL MEMORY ARRAY

COLUMN DECODER

F I G. 18

EP 0 387 887 A2

INPUT 1

INPUT 2

INPUT 3

80A

80B

80C

FUSE OR PRG ELEM

FUSE OR PRG ELEM

FUSE OR PRG ELEM

84

80D

86

FUSE OR PRG ELEM

FUSE OR PRG ELEM 80E

FUSE OR PRG ELEM 80F

OUTPUT

F I G. 19

F I G. 20 A

F I G. 20 B

F I G. 20 C

102  108   15C   104   20   15D   108   106

12A   12B

100   100   100

F I G. 21A

110

102   104   112   106

108   15C   21   15D   108

12A   12B

100   100   100

F I G. 21B

102   104   15B   106

108   114   15A   108   114   21   108   114

12A   12B

100   100   100

F I G. 21C

F I G. 22 A

F I G. 22 B

F I G. 22 C

F I G. 23 A

F I G. 23 B

F I G. 23 C

F I G. 24

F I G. 25

F I G. 26A

F I G. 26B

F I G. 26 C

F I G. 26 D

F I G. 27 A

F I G. 27 B

F I G. 27 C

F I G. 27 D